# EUROPEAN PATENT SPECIFICATION

(11) **EP 2 424 114 B1**
(45) Date of publication and mention of the grant of the patent: **20.04.2016**
(21) Application number: 11007046.3
(22) Date of filing: 30.08.2011
(51) Int. Cl.: H03M 1/12, H03K 4/02, H03M 1/56

(54) **Analogue-to-digital conversion**
Analog/Digital-Wandlung
Conversion analogique-numérique

(30) Priority: 31.08.2010 GB 201014418; 22.08.2011 US 201113214788
(43) Date of publication of application: 29.02.2012
(73) Proprietor: Broadcom Europe Ltd., Milton Road Cambridge, CB4 0WW (GB)
(72) Inventor: Danesh, Seyed, EH9 1ES Edinburgh (GB); Hurwitz, Jonathan Ephraim David, EH6 7PJ Edinburgh (GB)
(74) Representative: Jehle, Volker Armin

(56) References cited:
- WO-A2-2008/026129
- GB-A- 2 175 762
- US-A1- 2008 192 127
- SEYED DANESH ET AL: "A Reconfigurable 1 GSps to 250 MSps, 7-bit to 9-bit Highly Time-Interleaved Counter ADC with Low Power Comparator Design", IEEE JOURNAL OF SOLID-STATE CIRCUITS, IEEE SERVICE CENTER, PISCATAWAY, NJ, USA, vol. 48, no. 3, 1 March 2013 (2013-03-01), pages 733-748, XP011494566, ISSN: 0018-9200, DOI: 10.1109/JSSC.2013.2237672

## Description

### Field of the invention

The present invention relates to analog-to-digital conversion devices and methods of analog-to-digital conversion, in particular but not exclusively for use in moderately high-speed applications such as in communications devices.

### Background to the invention

Flash analog-to-digital converters (ADCs) achieve the highest conversion rates because an input voltage is compared with all quantization levels in parallel. However, the resolution of flash ADCs is limited by circuit area and input capacitance because of the exponential relationship to the number of comparators required. More recently, time interleaving of multiple ADCs has been applied to address these limitations. According to one approach, several high-resolution, lower speed ADCs are operated together in a time interleaved fashion to provide a high speed, high resolution ADC. Such ADC structure, however, introduces sampling noise and, because of inconsistent sampling interval timing may introduce intermittent and semi-random noise into the sampling process.

US 2008/0192127 A1 describes a solid-state imaging device including a reference-signal generating unit that generates plural kinds of reference signals for converting an analog pixel signal into digital data, a reference-signal selecting unit that selects any one of the plural kinds of reference signals, a comparing unit that compares the pixel signal and the selected reference signal, and a count unit that performs count processing in parallel with comparison processing in the comparing unit and stores a count value at a point when the comparison processing is completed.

According to the invention, there are provided an analog-to-digital converter as defined by independent claim 1 and a method of analog-to-digital conversion as defined by independent claim 10.

Further advantageous features of the invention are defined be the dependent claims.

Advantageously, the plurality of single slope ADCs are operable to receive a succession of time corresponding analog ramp signals that are spaced apart temporally, the time corresponding analog ramp signals received at successive single slope ADCs, such that each single slope ADC provides a digital representation of the analog input signal input using its time corresponding analog ramp signal.

Advantageously, the ramp generator comprises:
a first circuit for generating a plurality of first analog ramp signals; and
a plurality of second circuits, each second circuit respective to a single slope ADC and operable to produce a plurality of second ramp signals based upon a received first analog ramp signal.

Advantageously, the first circuit of the ramp generator is operable to produce a plurality of first analog ramp signals that are all out of phase with each other, and such that successive first analog ramp signals are out of phase by a single clock period.

Advantageously:
the first analog ramp signals comprise coarse ramp signals; and
the second analog ramp signals comprise fine ramp signals.

Advantageously the ramp generator comprises:
a plurality or resistive elements arranged in series so as to form a ring;
a switch network;
first and second power supplies, each at a different level; and
a controller arranged to control the switch network so as to connect a first power supply successively to each node of the resistor ring while also connecting a second power supply to a node diametrically opposite the node to which the first power supply is connected, such that the first and second supplies are always connected to diametrically opposed nodes and such that first and second power supply connections effectively rotate around the ring during ramp generation, thereby providing a plurality of ramp outputs, each from a different node of the resistor ring.

Advantageously, the resistor ring is comprised of four times as many resistors as ramp outputs, each ramp output being taken from two diametrically opposed nodes multiplexed together.

Advantageously, the ramp generator comprises two switches for each of the nodes, so as to enable selective connection of each node to each power supply.

Advantageously, each single slope ADC comprises a sample and hold circuit that is operative to sample the analog input signal and to maintain a voltage of the sampled analog input signal during conversion to a corresponding digital representation.

Advantageously, each sample and hold circuit comprises a single pole single throw switch in series with a capacitor, the switch being operative to couple the analog input signal to the capacitor for storage thereon.

Advantageously, each single slope ADC comprises a comparator that is operative to receive an analog input signal at a first input and an analog ramp signal at a second input.

Advantageously, each single slope ADC comprises a differential sample and hold circuit configured to sample one end of a differential input signal onto a first input of a comparator, and the other end of the differential input signal onto a second input of the comparator and then to apply two ramp signals of opposite slope such that one is applied to each input, the comparator output being operable to flip when its inputs reach a common level, the time taken to do so being determined by the differential input signal.

Advantageously, the ADC further comprises a digital counter, wherein each of the plurality of single slope ADCs comprises a digital memory coupled to the digital counter such that the digital counter is operative to cycle continuously and the ADC is configured to convey a value from the digital counter to each of the digital memories, the ADC being further operable to read a final value from each digital memory, the final value being dependent upon the analog input signal of the corresponding single slope ADC.

Advantageously, the ADC is operable to convert each value conveyed from the digital counter to a coded value according to a code in which two successive values differ in respect of only one bit, such as Gray code.

Advantageously, the analog ramp signal received by at least some of the single slope ADCs covers only a sub-range within the total possible range of the ADC.

Advantageously, the analog ramp signal received by each one of the single slope ADCs covers only a sub-range within the total possible range of the ADC.

Advantageously, a number of the single slope ADCs operate in parallel to convert a single analog input signal, each of the number of single slope ADCS being operable to receive an analog ramp signal that covers only a sub-range within the total possible range of the analog input signal, the sub-ranges together covering the total possible range.

Advantageously, the method further comprises receiving a succession of analog input signals and a succession of time corresponding analog ramp signals, each analog input signal and time corresponding analog ramp signal being spaced apart temporally, each of the analog input signal and corresponding analog ramp signal being received at successive single slope ADCs, such that each single slope ADC provides a digital representation of the analog input signal input thereto using the time corresponding analog ramp signal.

Advantageously, the method further comprises generating an analog ramp signal for each of the plurality of single slope ADCs using a single ramp generator, such that the plurality of ramp signals that are all out of phase with each other, and such that successive ramps signals are out of phase by a single clock period.

### Brief description of drawings

Further features and advantages of the present invention will become apparent from the following specific description, which is given by way of example only and with reference to the accompanying drawings, in which:
FIG. 1 shows a circuit diagram and a timing diagram for a single slope analog-to-digital converter;
FIG. 2 is a circuit diagram of an analog-to-digital converter according to the present invention;
FIG. 3 shows various timing, control, and input signals present during operation of the converter of FIG. 2;
FIG. 4A is a circuit diagram of a first embodiment ramp generator forming part of the circuit of FIG. 2;
FIG. 4B is a circuit diagram of a second embodiment of a ramp generator forming part of the circuit of FIG. 2;
FIGs. 5a and 5b are circuit diagrams of two variations on a fully differential sample and hold and comparison circuit, while FIG. 5c is a timing diagram for control of the circuits of FIGs. 5a and 5b;
FIG. 6 is a detailed circuit diagram of the digital memory and digital counter of the converter circuit of FIG. 2.
FIG. 7a is a graph of a ramp signal over time for the full input signal range;
FIG. 7b is a graph of a ramp signal over time for a sub-range of the full input signal range;
FIG. 8 is a circuit diagram of a section of an analog-to-digital converter featuring sub-ranging of the ramp signal;
FIG. 9a is a graph showing four ramp signals for the basic time-interleaved system of FIG. 2, each out of phase from one another by 90 degrees;
FIG. 9b shows how the four ramp signals of FIG. 9a can be used to produce Ramp A, B, C and D, for a sub-ranging analog-to-digital converter system such as those shown in FIGs. 8 and 11, each covering a quarter of the signal range;
FIG. 10 is a top level block diagram of a system according to an embodiment of the invention;
FIGs. 11, 12 13 are circuit diagrams of sections of an analog-to-digital converter featuring sub-ranging of the ramp signal according to alternative embodiments of the invention; and
FIG. 14 is a block diagram of a system according to another embodiment of the present invention.

### Detailed Description

According to a first embodiment of the present invention a composite analog-to-digital converter (hereinafter, ADC or composite ADC) includes a plurality of single slope ADCs, each single slope ADC being operative to receive an analog input signal and an analog ramp signal and to provide a digital representation of the analog input signal in dependence thereon, the single slope ADCs being configured such that an analog input signal received by one of the single slope ADCs is spaced apart in time from an analog input signal received by another single slope ADC and such that the analog ramp signals received by the single slope ADCs are out of phase with each other.

The single slope ADCs may be operable to receive a succession of analog input signals and a succession of time corresponding analog ramp signals, each analog input signal and time corresponding analog ramp signal being spaced apart temporally, each of the analog input signal and corresponding analog ramp signal being received at successive single slope ADCs in a cyclic fashion, such that each single slope ADC provides a digital representation of the analog input signal input thereto using the time corresponding analog ramp signal.

An ADC according to the present invention may include at least four single slope ADCs operable such that, at any one time, a first single slope ADC is in a reset mode, a second single slope ADC may be receiving an analog input signal a third single slope ADC may be converting an analog input signal to a corresponding digital representation and a fourth single slope ADC may be conveying its digital representation, for example, to processing circuitry.

Alternatively or in addition, the ADC may include at least one ramp generator that is operative to generate an analog ramp signal. The ADC may include a ramp generator for each single slope ADC. The ramp generator may be based in accordance with known practice.

More specifically, the ADC may include solely one ramp generator that is operative to simultaneously generate an analog ramp signal for each of the plurality of single slope ADCs. More specifically, the ramp generator may be operative to provide a plurality of ramp signals, which are all out of phase with each other and with successive ramps signals being out of phase by a clock period. The ramp generator may include any of those described below.

Alternatively or in addition, a single slope ADC may include a sample and hold circuit that is operative to sample an analog input signal and to maintain a voltage of the sampled analog input signal during conversion to a corresponding digital representation. The sample and hold circuit may include a single pole single throw switch in series with a capacitor, the switch being operative to couple the analog input signal to the capacitor for storage thereon.

Alternatively or in addition, a single slope ADC may include a comparator that is operative to receive an analog input signal at one of its inputs, e.g. the inverting input, and an analog ramp signal at another of its inputs, e.g. the non-inverting input. Hence, the comparator may be operative, in accordance with the normal operation of a single slope ADC, to switch its output when the analog ramp signal crosses the analog input signal.

A fully differential configuration may be advantageous depending on the circumstances of application. Hence, a single slope ADC may, alternatively or in addition, include a differential sample and hold circuit configured to sample one end of a differential input signal onto a first input of a comparator, and the other end of the differential input signal onto a second input of the comparator and then to apply two ramp signals of opposite slope such that one is applied to each input, the comparator output being operable to flip when its inputs reach a common level, the time taken to do so being determined by the differential input signal.

Alternatively or in addition, each single slope ADC may include a digital counter, operable to count to a digital value based upon the analog input signal, input thereto.

The ADC may be configurable to increase resolution at the expense of sampling rate or to increase the sampling rate at the expense of resolution by changing the ratio of clock speeds for different parts of the ADC. The different parts of the ADC may include at least the ADC input sample rate and the digital counter clock rate.

Alternatively or in addition, the ADC may further include a digital counter and each of the plurality of single slope ADCs may include a digital memory. The digital counter may be operative to cycle continuously and the ADC may be configured to convey a value from the digital counter to each of the digital memories, the ADC being further operable to read a final value from each digital memory, the final value being dependent upon the analog input signal of the corresponding single slope ADC. The digital memory may include at least one of SRAM and DRAM.

The ADC may be configured to convert each value conveyed from the digital counter to a coded value according to a code in which two successive values differ in respect of only one bit, such as Gray code.

A method of operating an ADC according to one or more embodiments of the present invention includes receiving an analog input signal and an analog ramp signal at each of a plurality of single slope ADCs and operating each of the single slope ADCs to provide a digital representation of the analog input signal in dependence on the analog input signal and the analog ramp signal, an analog input signal received by one of the single slope ADCs being spaced apart in time from an analog input signal received by another single slope ADC and the analog ramp signals received by the single slope ADCs being out of phase with each other. An output of the ADC is created based upon the output of the single slope ADCs.

A ramp generator constructed according to one or more embodiments of the present invention may include a plurality or resistive elements arranged in series so as to form a ring, a switch network, first and second power supplies, each at a different level, and a controller arranged to control the switch network. This structure connects a first power supply successively to each node of the resistor ring while also connecting a second power supply to a node diametrically opposite the node to which the first power supply is connected, such that the first and second supplies are always connected to diametrically opposed nodes and such that first and second power supply connections effectively rotate around the ring during ramp generation, thereby providing a plurality of ramped outputs, each from a different node of the resistor ring.

The first supply may be a positive supply and the second supply may be a negative supply. In one embodiment, the resistor ring has four times as many resistors as ramp outputs, each ramp output being taken from two diametrically opposed nodes multiplexed together. In such a case, each ramp output may be operable to provide oppositely sloped ramps simultaneously. The resistor ring may be physically arranged such that each of the nodes which are multiplexed together to provide a ramp output are physically located adjacent one another. The ramp generator may include two switches for each of the nodes, so as to enable selective connection of each node to each supply.

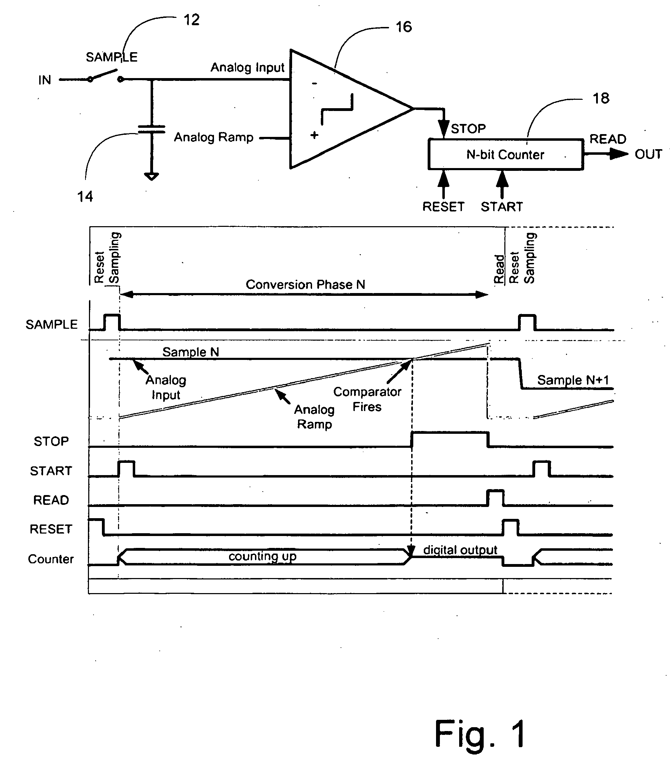

FIG. 1 shows a circuit diagram and timing diagram 10 for a known type of single slope analog-to-digital converter (ADC). The single slope ADC includes a sample and hold circuit formed from a switch 12 and a capacitor 14, a comparator 16 and a digital counter 18. As a first step, the digital counter is reset. Then, the switch 12 is closed and opened to thereby sample an analog input signal and hold its voltage level on she capacitor. The sampled voltage level is applied to the inverting input of the comparator 16 whilst an increasing analog ramp signal is applied to the non-inverting input of the comparator. Upon initial application of the ramp signal to the non-inverting input, the digital counter 18 is started. When the analog ramp signal crosses the sampled voltage level, the comparator switches to thereby stop the digital counter. The count held in the counter is then read out, with the count being a digital representation of the sampled voltage.

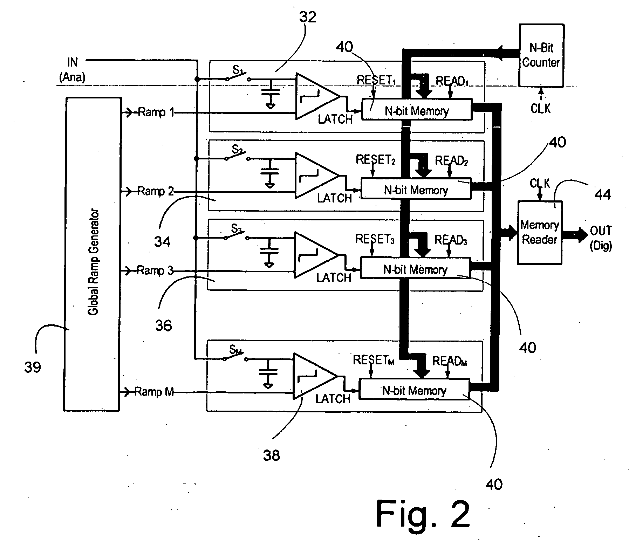

FIG. 2 shows a circuit diagram of an ADC according to the present invention. The ADC includes M single slope ADCs 32, 34, 36, and 38 in a parallel arrangement, each single slope ADC 32, 34, 36, and 38 forming a row of the ADC. A global ramp generator 39 (such as that described later) provides a plurality of temporally spaced apart ramp signals, each ramp preferably being a single clock cycle out of phase compared to the previous ramp. Of course, it is equally within the scope of the invention to simply provide a plurality of separate ramp generators for each single slope ADC, or some other such combination.

Each single slope ADC may be of the same form and function as the single stope ADC of FIG. 1 except as follows. In each single slope ADC of the circuit of FIG. 2, the digital counter is replaced with a digital memory 40, which receives a count value from a global digital counter 42 as described below in more detail. The ADC of FIG. 2 also includes a memory reader 44 that is operative to read values from each digital memory 40. In an alternative, un-illustrated embodiment, each single slope ADC of the circuit of FIG. 2 includes a digital counter instead of the digital memory and thus corresponds in form and function to the single slope ADC shown in FIG. 1. Generally, the single slope ADCs 32, 34, 36, 38 operate in parallel and out of phase with each other to thereby derive an M-fold increase in conversion throughput.

In use, the ADC of FIG. 2 may be operative such that the first single slope ADC receives a first analog input signal and begins conversion of the first analog input signal into a first digital representation. Then the ADC may be operative such that the second single slope ADC receives a second analog input signal and begins conversion of the second analog input signal into a second digital representation, reception of the second analog input signal taking place a predetermined period of time after reception of the first analog input signal. The first and second analog input signals may be sampled from a same signal source, e.g. signal source in a communications devices or an output from a sensor. Hence, the ADC may be used to achieve a moderately high speed conversion rate that compares, for example, with the slow conversion rate achieved with one single slope ADC or the fast conversion rate achieved with a flash ADC.

The analog ramp signal (i.e. a first ramp signal) received by the first single slope ADC may be in phase with the reception of the first analog input signal. The analog ramp signal (i.e. a second ramp signal) received by the second single slope ADC may be in phase with the reception of the second analog input signal. Hence, the first and second ramp signals may be out of phase with each other by the predetermined period of time betwee reception of the first and second analog in put signals.

More specifically, the ADC may be configured such that each of the single slope ADCs receives a plurality of spaced apart pairs of analog input signals and analog ramp signals. Thus, the first and second single slope ADCs may be operative perform a series of conversions in a reciprocal fashion.

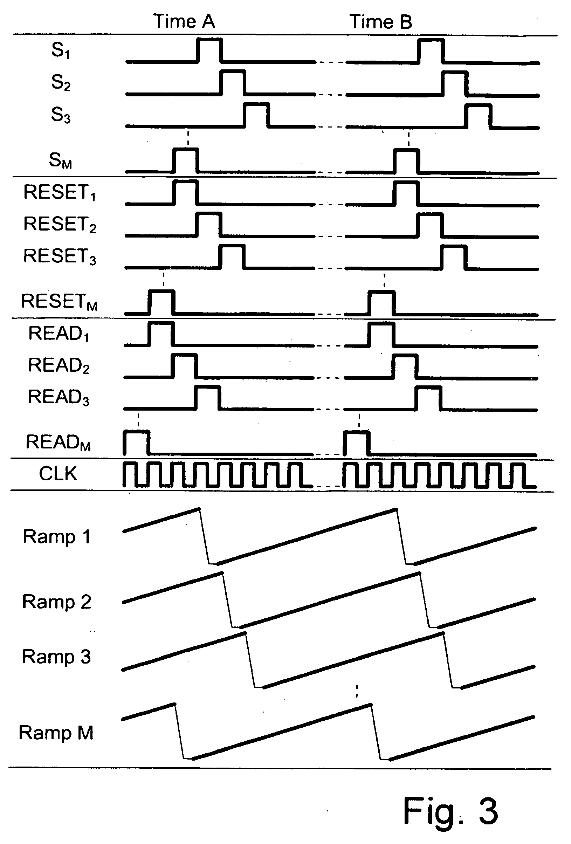

FIG. 3 is a timing diagram of an operational embodiment of the devices of FIG. 2. Two arbitrary time points, A and B, have been highlighted (shaded) and will be discussed by way of example. At time A, The first single slope ADC (row 1) 32 is sampling the input, the second single slope ADC (row 2) 34 is in reset, the third single slope ADC (row 3) 36 is reading out the result of the conversion, and the Mth single slope ADC (row M) 38 has just finished sampling in the previous clock cycle and is now busy converting. At time point B, row 1 32 is in reset, row 2 34 is reading out the value of the conversion, row 3 36 is almost at the end of its conversion period, and row M 38 is sampling the input. Indeed, at any moment in time, one row is in reset, one is sampling the input, one row is reading out, and all other rows are mid conversion. At the next clock cycle the sampling, resetting, and reading move forward to the next rows in a circular way, with row 1 and row M being next to each other in the circle. In this example, each ramp signal, Ramp1 to Ramp M, is out of phase from the preceding ramp signal by one clock cycle.

In the example of figure 3, M = 2^{N} since the clock for the N-bit counter, and the Sample/Reset/Read base clocks are the same. Consequently, the number of clock cycles required for conversion, which is 2^{N}, should equal the number of rows available in the system for this example. As mentioned before, the N-bit counters at the back of each row have been replaced with an N-bit memory latching from the counter (data) bus. Preferably, the count sequence each row receives should be out of phase by one code from its neighbouring row, since each row is out of phase by one clock cycle from its neighbours in its conversion cycle. Here the count value they each receive is identical to a continuously cycling N-bit counter, meaning that the digital output from each row has a fixed offset equal to its row number. To correct for this, the digital output from row X, where X is the row number between 1 to M, should be subtracted by X. Also, each row has a latency of 2^{N} clock cycles and therefore the total ADC has a 2^{N} clock cycles latency as well.

In the above example, the rotation speed of the ramp-generator, the sampling switch's sampling rate and the digital back-end sampling rate are all equal (that is the counter clock and the sample/reset/read base clocks are the same). However, this does not necessarily need to be the case. In fact, the relative sampling rates of these 3 subsystems can be changed in real-time, effectively building a reconfigurable ADC. It should be appreciated that this reconfiguration can be achieved without physically changing the device, but just by altering these sampling rates relative to each other. For example, if the ADC is configured according to the FIG. 3 example, with all the clocks operating at 1GHz, and having 128 rows, the ADC operates as a 7-bit, 1GHz ADC. But, should the ladder be adjusted to work at 500MHz, and sample at 500MHz, while the digital back-end is still sampling at 1GHz, The ADC operates as an 8-bit 500MHz ADC. It should of course be appreciated that the above FIGs. are provided purely as examples. Consequently, the resolution and sampling rate of the overall converter can be traded off for each other (in real time) by adjusting the relative operation speeds of the different sub-sections.

### Implementation of sub-blocks

Here follows one or more implementations of the sub-blocks and support circuitry necessary for the operation of the ADC of FIG. 2. It should be appreciated that these are shown by way of example only and other suitable alternatives can be envisaged and substituted as appropriate.

### Parallel Ramp Generator

As explained above, a total of M different ramps, all out of phase from one another by a single clock period, require to be generated for this system. In parallel counter ADC systems, only one ramp is needed which is usually generated from a Digital to Analog Converter (DAC), either from a resistor string or current source array. Monotonicity of the ramp is of great importance in counter based converters. Implementation of M different current or resistor string DAC blocks is not practically feasible and therefore a novel folded rotating resistor ladder generating M out of phase ramps is proposed.

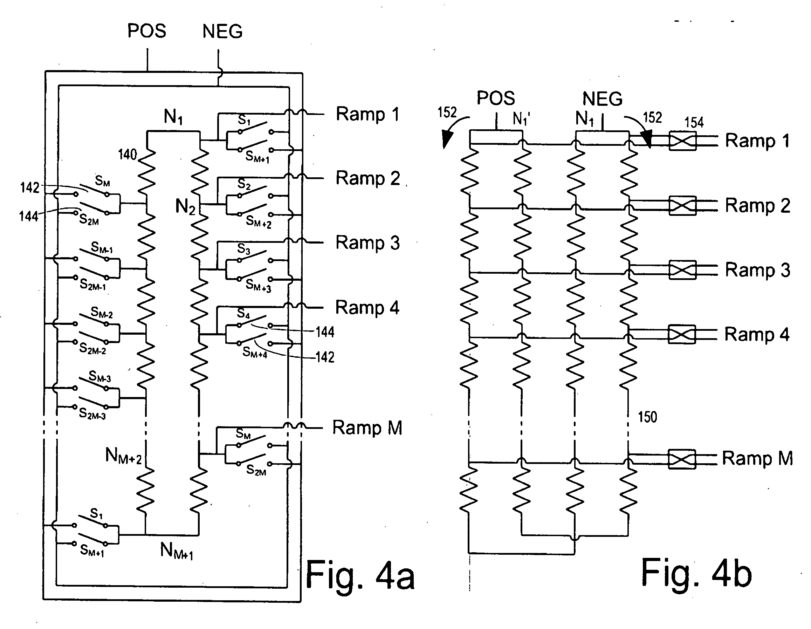

FIG. 4a shows a parallel ramp generator resistor string 140. The resistor string forms a ring, with each node between adjacent resistors being connected to a positive supply rail, in each case via a switch 142 and also to a negative supply rail, in each case via a switch 144, such that each node of the resistor string can either connect to a positive reference voltage (POS) or a negative reference voltage (NEG).

As there are 2M nodes, there are a total of 4M switches 142, 144 that are operated in pairs in accordance with a total of 2M controlling signals S₁ to S_{2M}. At each clock cycle, only one of these signals is high, and will operate a pair of switches such that one node is connected to POS and the node diametrically opposite this in the ring is connected to NEG. At the next cycle, the pair of switches operated is that which connects the nodes adjacent to those previously connected, the connections remaining diametrically opposite. In this way, each signal S₁ to S_{2M} goes high in turn, and as a consequence connection to POS and NEG effectively rotates around the ring, moving a node at a time at each clock cycle. Therefore, if it is assumed that at time=0, signal S₁ is high, node N₁ on the ladder will be connect to the NEG and node N_{M+1} will be connected to POS. In the following clock cycle signal S₁ will go low and signal S₂ will go high, and N₂ will connect to NEG and node N_{M+2} will connect to POS. As signals S₁ to S_{M} go high in order, the signal at Node N₁ will look like a rising (stepped) ramp from NEG to POS, the smoothness of the ramp being dependent on the number of resistors in the string. However, when signals S_{M+1} to S_{2M} go high in order, Node N₁ will produce a falling ramp, which is undesirable, as during that period the signal Ramp 1 should ideally be another rising ramp.

FIG. 4b shows an extended resistor string 150 which can be used to address the above problem, the resistor string having twice the number of resistors arranged essentially in a ring. However, as a practical measure, the resistor ring is actually realized as a folded figure of 8, as shown in FIG. 4b, for reasons explained later. Switches are not shown in this drawing for clarity, but the circuit is switched in a similar way to FIG. 4a, such that nodes on the resistor ring diametrically opposite are simultaneously switched to a supply rail, one carrying a positive supply and one carrying a negative supply. In this case, only one connection is shown to each supply, POS and NEG. As before, this switching is operated such that this connection to POS and NEG effectively rotates around the ring, moving a node at a time at each clock cycle. The direction of this rotation for each supply is shown by the arrows 152.

In the first half of the signal switching sequence (S₁ to S_{2M}), up to signal S_{M}, signal Ramp 1 is taken from node N₁; when signal S_{M+1} goes high and then throughout the second half of the sequence, signal Ramp 1 is then taken from N_{M+1}. When signal S₁ goes high again, the sequence is repeated. As with the arrangement of FIG. 4a, a complete switching sequence through signals S₁ to S_{2M} results in two ramps on node N₁ (similarly on nodes N₂ - N_{M}, each one clock cycle out of phase from the previous node), one rising and one falling. However, at the same time on node N₁', diametrically opposite N₁, two opposite ramps are also being generated, such that when the ramp generated at node N₁ is rising, the ramp generated at node N₁' is falling and *vice versa.* Nodes N₁ and N₁' are multiplexed together such that an always rising ramp signal can be obtained, the multiplexer 154 swapping connection between nodes N₁ and N₁' as appropriate (by always rising, what is actually obtained is a sawtooth signal comprising two "teeth" or rising ramps for every complete switching sequence through signals S₁ to S_{2M}). Furthermore, because one node is generating a rising ramp at the same time that its opposite node is generating a falling ramp, it should be appreciated that the multiplexer output can also generate an always falling ramp signal at the same time as the always rising ramp signal. This is put to good use where the comparator is implemented as a fully differential system, and therefore requires corresponding rising and falling ramps, as described below.

As mentioned previously, the resistor ring is actually realised as a folded figure of 8. In using this physical configuration, node N₁ and node N₁' are effectively next to each other, as are nodes N₂ and N₂' etc. up to N_{M} and N_{M}'. Having the resistor ring arranged such that corresponding ramp output nodes are close together and on the same row makes the device easier to manufacture on silicon.

### Sampling, Ramping and Analog Front End

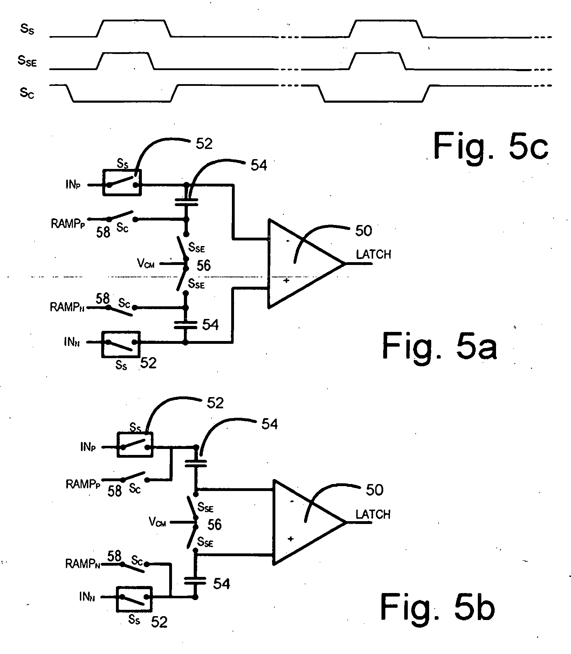

FIG. 5a and FIG. 5b both show two variations on a fully differential system for comparing the ramp and analog input so as to latch the N-bit memory/digital counter. FIG. 5c is a timing diagram applicable for the operation of both variations. FIGs. 5a and 5b show a comparator 50, the output of which latches a digital counter. In this example, a folded cascode amplifier is used for the comparator. Both inputs of the comparator 50 are connected to the differential input signal IN_{P}, IN_{N} via pair of switches 52 (controlled by signal S_{S}). Two capacitors 54, pairs of switches 56, 58, common-mode voltage V_{CM} and ramp signal inputs RAMP_{P}, RAMP_{N} are arranged as shown. Switch pair 56 is controlled by signal S_{SE} and switch pair 58 is controlled by signal S_{C}. The control of these switches is shown in the timing diagram of FIG. 5c.

Considering FIG. 5a in particular, this employs a technique known as Bottom Plate Ramping. First of all the differential input is sampled onto two capacitors 54. During the ramping phase, rather than connecting the ramp signals to other inputs of the comparator, they are used to move the bottom plates of the sampling capacitors 54. RAMP_{P} is a rising ramp from Vₘᵢₙ to Vₘₐₓ, and RAMP_{N} is falling ramp. When ramping in this way the comparator 50 always fires when its inputs are at common-mode. This means at the time of firing the comparator has the same internal DC conditions, and hence the same open loop gain, bandwidth, and delay regardless of the signal magnitude. Using this technique, the delay from the inputs crossing to the output of comparator firing is always a constant value, independent of the signal magnitude. This does result in a constant offset for the entire ADC, but this is easily corrected for in digital. However, the magnitude of leakage on the sampling capacitors is signal dependent since the length of time until firing is signal dependent. This leakage is on both capacitors and hence comes through as common-mode error. Furthermore, some common-mode rejection is required. Therefore, the comparator does not always fire exactly with inputs at common-mode and some care is required to achieve a gain-bandwidth product (GBW) in the comparator to eliminate the signal dependent delay below one least significant bit.

### Digital Memory Backend and Readout Circuit

As previously mentioned, the backend counter of the single slope ADC is replaced with a memory unit. The ADC may be configured to convey a value from a cyclically counting common digital counter to each of the digital memories. A value may be conveyed, i.e. read, from the digital counter to a digital memory of a row when the row comparator latches. Hence, values conveyed from the digital counter to respective digital memories may not correspond to absolute digital representations of converted analog input signals. More specifically, a value conveyed from the digital counter to a single slope ADC may be offset from an absolute digital representation of the converted analog input signal by an amount corresponding to the row of the ADC used for that specific conversion. Using an example where there are six rows, an offset amount for the digital counter value for the sixth row may be higher than an offset amount for the digital counter value for the fifth row. Hence, the ADC may subtract the appropriate offset value from the digital counter value for a specific row.

The memory unit can be implemented as an SRAM or DRAM structure. An SRAM approach is larger in each row and requires a tree for readout, while a DRAM solution consumes less space in each row, and requires a sense comparator for read out.

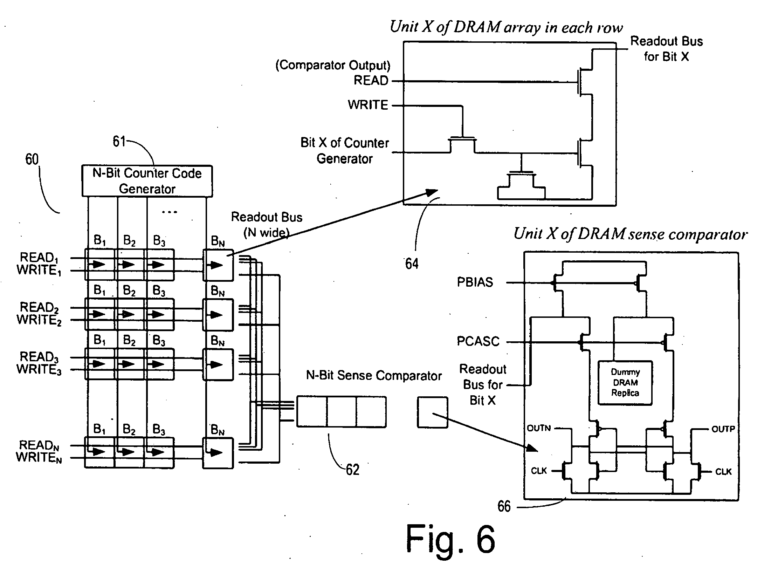

FIG. 6 shows a custom DRAM cell 60 with N-bit counter 61 and a static sense comparator 62, which is used in this embodiment of the ADC. Also shown in detail are a single unit of the DRAM cell array 64 and a single unit of the DRAM sense comparator 66. Due to the high readout bus capacitance, the current from each DRAM unit is folded using a biasing circuit in the sense comparator before being fed to a latch.

### Counter Generator and Driver

Switching of comparators in the plurality of single slope ADCs may be asynchronous to the clocking of the digital counter. Hence, there may be a risk that at a time of switching of a comparator the digital counter may be at a transition between first and second successive values with a possible consequence that a first part of the digital memory may receive a part of the first value and a second part of the digital memory may receive a part of the second value. Where binary code is used, a large error may result. Therefore, the ADC of any of the embodiments disclosed herein may additionally convert each value conveyed from the digital counter to a coded value according to a code in which two successive values differ in respect of only one bit, such as Gray code.

### Further Embodiments

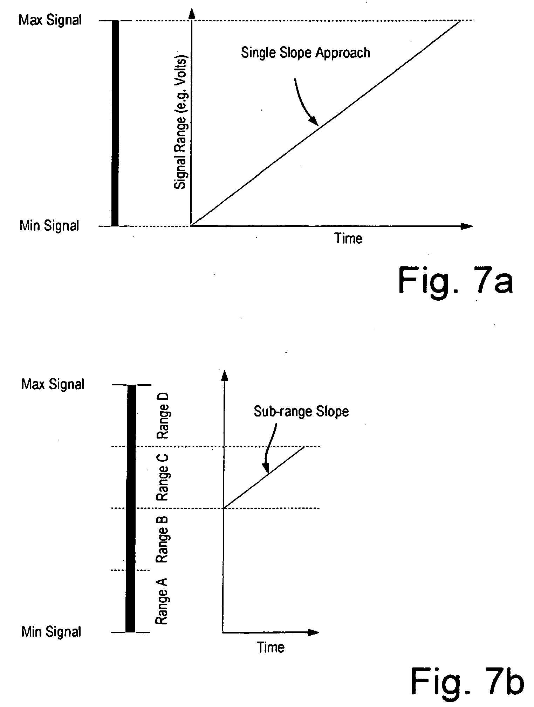

One issue with single-slope ADCs, whether used in isolation or in a time-interleaved implementation as described above, is latency. This results from the time taken from sampling the analog signal to the digital signal appearing at the output necessarily being equal to the length of the ramp. To reduce the latency of the system, ideally, one would like to reduce the length of the ramp; however, the length of the ramp is proportional to the full signal range, and therefore each of the ramps fed to each column cover the full signal range. The comparator firing point, that is the point where the ramp voltage matches the sampled input voltage, could be anywhere in that signal range. This is illustrated in FIG. 7a.

To address this issue, it is proposed to use a sub-ranging system, wherein the full signal range is divided into sub-ranges. In the example shown in FIG. 7b, the signal full range is divided into four sub-ranges, ranges A, B, C, and D. Each sub-range represents a quarter of the full signal range. In a sub-ranging ramp based system, if it is chosen to only look (say) at Range C of the full signal range, the ramp required for the row only needs to cover a quarter of the full-range. Since the ramp only covers a sub-section of the full signal range, the total length of time required for the ramp will be reduced. Should the signal not be in Range C, the converter would fail to digitise the input signal.

Sub-ranging is a system-level approach to reduce latency, but can be implemented in many different ways. The following paragraphs will explain three different implementations to achieve sub-ranging.

### Sub-ranging using Parallelism

As described above, in sub-ranging systems, the full input range is divided into sub-ranges, and the input is compared within this sub-range. In a parallel sub-ranging scheme for the time-interleaved counter ADC proposed, the signal range is divided into sub-ranges, and the input is sampled multiple times simultaneously, the amount of times being equal to the number of sub-ranges. A sub-ranging ramp is fed to each sampling and comparator sub-system, and many conversions of the same signal are done in parallel.

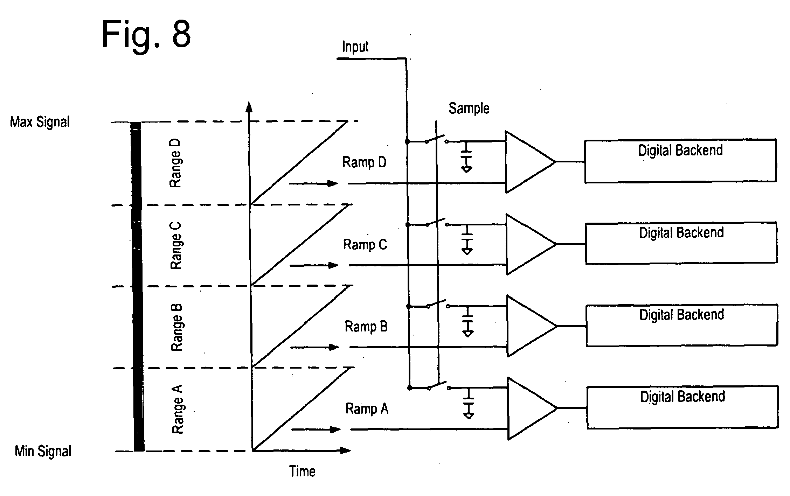

FIG. 8 shows a sub-ranging sub-system for a single counter based ADC. Again, the input range is divided into 4 sub-ranges, although the skilled person will recognise this is only an example, and the range can be divided into many more or less sub-ranges. Note that the example shown in FIG. 8 is a simple sub-ranging system shown by way of example, and does not include time-interleaving.

In this example, a total of four channels are used to achieve a parallel sub-ranging system of four ranges. The input is sampled on to the four channels simultaneously. Four different ramps that are in phase with each other, but cover different sections of the input signal range, begin ramping and are fed to the different rows. Each row independently compares the sampled input signal against the ramp it receives, which covers a sub-range of the signal full range. Since the input signal can only be in one of the signal ranges, only one of the rows will ever fire. This shows which range the signal is in (A, B, C or D). The digital counter value stored in the digital backend for the firing comparator represents the exact point within that range which the signal is in, and hence the digital value equivalent to the input signal can be determined.

It is now proposed to combine the above implementation of a parallel sub-ranging system with the time-interleaved implementation previously explained, so as to obtain a time-interleaved sub-ranging counter ADC. In the basic time-interleaving system, the latency was proportional to resolution (the steps required in the backend counter and ramp). In the proposed combined system, the comparators are paired up to build sub-ranging sub-systems. Therefore, for a given number of comparators, the latency is reduced, at the cost of a reduction in the effective sampling rate of the overall converter, since more than one row now deals with only one input signal.

Referring back to FIG. 4a and 4b, and to FIG. 8, it can be appreciated that ramps A, B, C and D (while not spatially next to each other) are already produced by the ramp-generator described in FIG. 4.

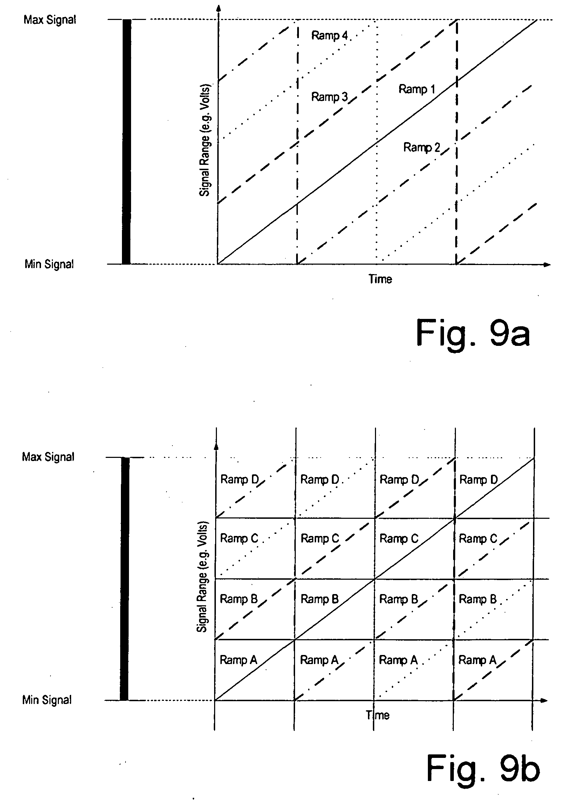

FIG. 9a shows the four ramps for the basic time-interleaved system, each out of phase from one another by 90-deg. FIG. 9b shows how these ramps can be used to produce Ramp A, B, C and D, for sub-ranging system where they each cover a quarter of the signal range. It can be seen that it is possible to obtain (without change in hardware) the necessary four in-phase ramps, each covering a quarter full range whereupon they restart, in addition to the four ramps, out of phase by 90-degress from one another, each covering the signal full range.

### Sub-ranging by Selection

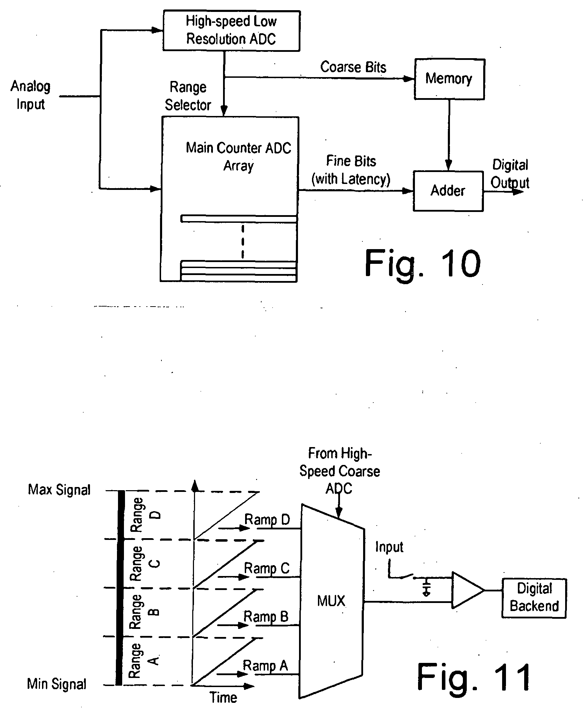

Referring back to FIG. 7b, if there was a way of knowing which sub-range the input signal was in, one could apply the correct ramp to the comparator. In a sub-ranging system by selection, a coarse ADC is used in parallel to the main bank of counter ADCs. FIG. 10 shows a block diagram of such a system. The analog input is fed to the main counter based ADC array as before, but in addition, this analog input is also fed to a high-speed very low-resolution ADC. For the example in FIG. 7b, this would be a 2-bit ADC. Each row of the counter ADC receives four ramps, one for each sub-range of the input signal. This is shown in FIG. 11. The high-speed ADC in parallel informs each row which ramp it should use. This information is also stored in memory, since it represents the 2 coarse (MSB) bits from the output. Once the counter ADC identifies the value of the input signal within this sub-range the digital output is added to the appropriate data from memory to produce the digital output.

### Sub-ranging by Subtraction/Addition

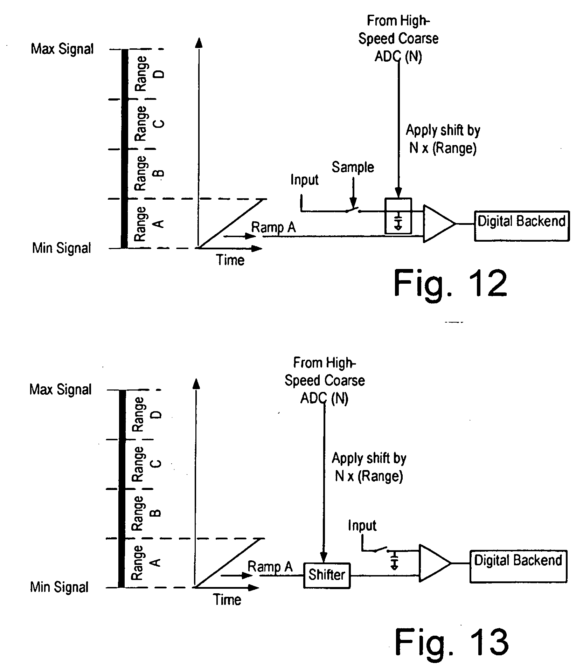

Referring back to FIG. 7b, if there was a way of knowing which sub-range (Range) the input signal was in, one could subtract a fixed number of range sizes from the input signal, so the signal always lands in Range-A prior to conversion or, alternatively, a fixed amount of range sizes could be added to Ramp A, so it is always covers the input signal. The top-level block diagram of the system is the same as FIG. 10; however, the two subtraction/addition approaches (applied to input and applied to ramp) are shown in FIG. 12 and FIG. 13.

In FIG. 12, the input signal is first sampled onto a capacitor and is then shifted by an amount based on the information from the high-speed ADC. The amount by which the input signal is shifted is equal to the code from the high-speed ADC times the size of a sub-range. Due to this shift, the input will fall inside Range A, and Ramp A can then be used to perform the conversion. This shifting can be done in a number of ways, for example by "moving the bottom plate" of the capacitor by a fixed amount (that is changing the signal level on this bottom plate).

In FIG. 13, the signal is sampled as before, but the ramp is then "moved down" a fixed amount, equal to the high-speed ADC code times the range size. This shifting can also be done for example with a precharged capacitor in series.

It will be appreciated that this Subtraction/Addition sub-ranging embodiment only requires one ramp per row compared to the selection sub-ranging embodiment. However, the subtraction/addition needs to be performed with great accuracy, in the order of the accuracy of the overall converter, which may present a difficulty, in practice.

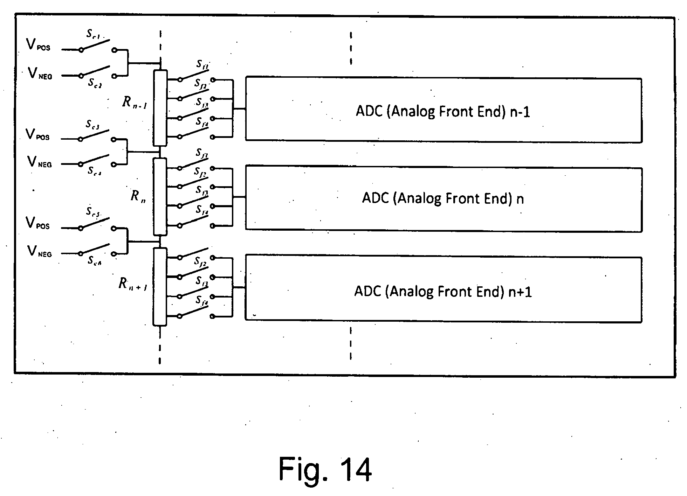

FIG. 14 is a block diagram of a system according to another embodiment of the present invention. With the prior embodiments, the proposed architecture requires the number of rows of the ADC (corresponding to the number of single slope ADCs) to be similar (or in a similar order of magnitude) to the number of unit resistors in the rotary resistor ladder, and close to the overall resolution step, for the architecture to be practically implementable. For example, if 128 rows were to be implemented, then 128 unique ramp signals would be required. To realize such signal generation, a 128 unit resistor is formed in the ring configuration. If the system were operated with a 7-bit resolution, for example, each ramp would have 128 unique voltage levels (since the resistor ladder is 128-elements). If an 8-bit system (when only 128 ADC rows are implemented) 256 unit resistors may be used, only bringing out every second resistor, or implementing 128 unit resistors, but using an interpolating filter to smooth the ramp to 8-bit performance. Both these options have been described above.

Considering an 8 row ADC embodiment of the present, where this number of ADC rows have been chosen for implementation efficiency for the ADC, and an 8-bit system is desirable, 256 unique levels would be supported. Hence, either a 256 element resistor ring would be used, or a large interpolation filter would be used. The first option (the 256-element ring) is impractical to realize in layout, requires very high rotating operation from the ring, and power and area overhead of the required extra switches can significantly limit the performance. Interpolating from an 8 unit resistor ring to effectively an 8-bit system requires a large filtering element and results in a large loss in the ramp full range.

Thus, during design, a correlation between the number of ADC rows, the number of unit resistors in the ramp-generator, and effective resolution exists, and limits the trade-offs in design, especially in thinner geometries. Ideally, these three design tradeoffs should be broken to realize a more efficient ADC.

Therefore, according to another aspect of the present invention, the ramp-generator includes a progression of more unique levels and a smaller number of timing circuits. Looking at the ramp-generator as part of the system, moving to smaller geometries will make the ramp-generator the bottleneck of the system, and potentially a slight change in architecture would be needed. According to this aspect of the present invention, a segmentation in the ramp-generator is employed, where the main ramp generator performs a coarse rotation, and fine rotation is performed locally. This allows more unique resolution steps in the output ramps, while limiting the global number of switches, timing circuits, and variable output resistance.

FIG. 14 illustrates the proposed system, which works particularly well when there is a lower number of ADC rows, compared to unique quantization levels, which will be the case as one moves to thinner geometries. With this embodiment, a set of coarse switches operates similarly to these described above but connects different parts of the main resistor ring to either V_{POS} or V_{NEG}, performing the rotating of the main resistor ladder. Then, a number of fine-switches are employed locally to connect an ADC row to different sub-sections of one unit resistor. Crucially, when stepping through the fine switches one by one, the main resistor ring is no longer rotating, but, in effect, a particular row ADC is walking down the resistor ring. Implementing this for the full ring is practically impossible due to layout limitation since each ADC row would require to be able to connect to every point of the resister ring, while in a segmented system here it only requires connection to parts of the resistor ring, which is local to that row, hence not introducing any layout limitations.

The terms "circuit" and "circuitry" as used herein may refer to an independent circuit or to a portion of a multifunctional circuit that performs multiple underlying functions. For example, depending on the embodiment, processing circuitry may be implemented as a single chip processor or as a plurality of processing chips. Likewise, a first circuit and a second circuit may be combined in one embodiment into a single circuit or, in another embodiment, operate independently perhaps in separate chips. The term "chip," as used herein, refers to an integrated circuit. Circuits and circuitry may include general or specific purpose hardware, or may include such hardware and associated software such as firmware or object code.

The present invention has also been described above with the aid of method steps illustrating the performance of specified functions and relationships thereof. The boundaries and sequence of these functional building blocks and method steps have been arbitrarily defined herein for convenience of description. Alternate boundaries and sequences can be defined so long as the specified functions and relationships are appropriately performed. Any such alternate boundaries or sequences are thus within the scope of the claimed invention.

The present invention has been described above with the aid of functional building blocks illustrating the performance of certain significant functions. The boundaries of these functional building blocks have been arbitrarily defined for convenience of description. Alternate boundaries could be defined as long as the certain significant functions are appropriately performed. Similarly, flow diagram blocks may also have been arbitrarily defined herein to illustrate certain significant functionality. To the extent used, the flow diagram block boundaries and sequence could have been defined otherwise and still perform the certain significant functionality. Such alternate definitions of both functional building blocks and flow diagram blocks and sequences are thus within the scope of the claimed invention. One of average skill in the art will also recognize that the functional building blocks, and other illustrative blocks, modules and components herein, can be implemented as illustrated or by discrete components, application specific integrated circuits, processors executing appropriate software and the like or any combination thereof.

As may be used herein, the terms "substantially" and "approximately" provides an industry-accepted tolerance for its corresponding term and/or relativity between items. Such an industry-accepted tolerance ranges from less than one percent to fifty percent and corresponds to, but is not limited to, component values, integrated circuit process variations, temperature variations, rise and fall times, and/or thermal noise. Such relativity between items ranges from a difference of a few percent to magnitude differences. As may also be used herein, the term(s) "coupled to" and/or "coupling" and/or includes direct coupling between items and/or indirect coupling between items via an intervening item (e.g., an item includes, but is not limited to, a component, an element, a circuit, and/or a module) where, for indirect coupling, the intervening item does not modify the information of a signal but may adjust its current level, voltage level, and/or power level. As may further be used herein, inferred coupling (i.e., where one element is coupled to another element by inference) includes direct and indirect coupling between two items in the same manner as "coupled to." As may even further be used herein, the term "operable to" indicates that an item includes one or more of power connections, input(s), output(s), etc., to perform one or more its corresponding functions and may further include inferred coupling to one or more other items. As may still further be used herein, the term "associated with," includes direct and/or indirect coupling of separate items and/or one item being embedded within another item. As may be used herein, the term "compares favorably," indicates that a comparison between two or more items, signals, etc., provides a desired relationship. For example, when the desired relationship is that signal 1 has a greater magnitude than signal 2, a favorable comparison may be achieved when the magnitude of signal 1 is greater than that of signal 2 or when the magnitude of signal 2 is less than that of signal 1.

The present invention has also been described above with the aid of method steps illustrating the performance of specified functions and relationships thereof. The boundaries and sequence of these functional building blocks and method steps have been arbitrarily defined herein for convenience of description. Alternate boundaries and sequences can be defined so long as the specified functions and relationships are appropriately performed. Any such alternate boundaries or sequences are thus within the scope of the claimed invention.

Moreover, although described in detail for purposes of clarity and understanding by way of the aforementioned embodiments, the present invention is not limited to such embodiments. It will be obvious to one of average skill in the art that various changes and modifications may be practiced within the scope of the invention, as limited only by the scope of the appended claims.

## Claims

1. An analog-to-digital converter, ADC, comprising:
a plurality of single slope ADCs (32, 34, 36, 38), each single slope ADC comprising:
an analog input operable to receive an analog input signal;
a ramp input operable to receive an analog ramp signal;
a comparator (16) operable to compare the analog input signal to the analog ramp signal; and
an output operable to produce a digital representation of the analog input signal based upon the comparison, wherein the plurality of single slope ADCs (32, 34, 36, 38) are operable to receive the analog ramp signals that are out of phase with each other and the analog input signals that are spaced apart in time from each other and are coupled to a common analog input of the analog-to-digital converter; and
a ramp generator (39) that is operable to generate the analog ramp signals for each of the plurality of single slope ADCs (32, 34, 36, 38); and
digital output circuitry operable to receive the outputs from each of the plurality of single slope ADCs (32, 34, 36, 38) and to produce a digital representation of the analog input signal based thereupon;
wherein the plurality of single slope ADCs (32, 34, 36, 38) comprise four single slope ADCs and
the four single slope ADCs are operable such that at any time of operation:
a first single slope ADC is in a reset mode;
a second single slope ADC is receiving the analog input signal;
a third single slope ADC is converting the analog input signal to a corresponding digital representation; and
a fourth single slope ADC is conveying a digital representation of an analog input signal of a previous clock cycle;
wherein the ramp generator (39) comprises circuitry to simultaneously generate the analog ramp signal for each of the plurality of single slope ADCs (32, 34, 36, 38);
wherein the ramp generator (39) is operable to produce a plurality of ramp signals that are all out of phase with each other, and such that successive ramp signals are out of phase by a single clock period.

2. The ADC of claim 1, wherein the plurality of single slope ADCs (32, 34, 36, 38) are operable to receive a succession of time corresponding analog ramp signals that are spaced apart temporally, the time corresponding analog ramp signals are received at successive single slope ADCs, such that each single slope ADC provides a digital representation of the analog input signal input using its time corresponding analog ramp signal.

3. The ADC of claim 1, wherein the ramp generator (39) comprises:
a first circuit for generating a plurality of first analog ramp signals; and
a plurality of second circuits, each second circuit respective to a single slope ADC and operable to produce a plurality of second ramp signals based upon a received first analog ramp signal.

4. The ADC of claim 3, wherein the first circuit of the ramp generator (39) is operable to produce a plurality of first analog ramp signals that are all out of phase with each other, and such that successive first analog ramp signals are out of phase by a single clock period.

5. The ADC of claim 3, wherein:
the first analog ramp signals comprise coarse ramp signals; and
the second analog ramp signals comprise fine ramp signals.

6. The ADC of claim 1, wherein the ramp generator (39) comprises:
a plurality or resistive elements arranged in series so as to form a ring;
a switch network;
first and second power supplies, each at a different level; and
a controller arranged to control the switch network so as to connect a first power supply successively to each node of the resistor ring while also connecting a second power supply to a node diametrically opposite the node to which the first power supply is connected, such that the first and second supplies are always connected to diametrically opposed nodes and such that first and second power supply connections effectively rotate around the ring during ramp generation, thereby providing a plurality of ramp outputs, each from a different node of the resistor ring.

7. The ADC of claim 6, wherein the resistor ring is comprised of four times as many resistors as ramp outputs, each ramp output being taken from two diametrically opposed nodes multiplexed together.

8. The ADC of claim 6, wherein the ramp generator (39) comprises two switches for each of the nodes, so as to enable selective connection of each node to each power supply.

9. The ADC of claim 1, wherein each single slope ADC comprises a sample and hold circuit that is operative to sample the analog input signal and to maintain a voltage of the sampled analog input signal during conversion to a corresponding digital representation.

10. A method of analog-to-digital conversion comprising:
receiving an analog input signal and an analog ramp signal at each of a plurality of single slope analog-to-digital converters ADCs, (32, 34, 36, 38) each analog input signal being coupled to a common analog input signal to be converted; wherein the plurality of single slope ADCs comprise four single slope ADCs; and
comparing the analog input signal and the analog ramp signal; and
operating each of the single slope ADCs to provide a digital representation of the analog input signal in dependence on the analog input signal and the analog ramp signal,
an analog input signal received by one of the single slope ADCs (32, 34, 36, 38) being spaced apart in time from an analog input signal received by another single slope ADC and the analog ramp signals received by the single slope ADCs (32, 34, 36, 38) being out of phase with each other, wherein successive ramp signals are out of phase by a single clock period;
wherein, at any one time, a first single slope ADC is in a reset mode, a second single slope ADC is receiving the analog input signal, a third single slope ADC is converting the analog input signal to a corresponding digital representation and a fourth single slope ADC is conveying a digital representation of an analog input signal of a previous clock cycle; operating a ramp generator to simultaneously generate the analog ramp signals for each of the plurarity of single slope analoge-to-digital converter, the analog ramp signals being all out of phase with each other and successive ramp signals being out of phase by a single clock period.

11. The method of claim 10 further comprising receiving a succession of analog input signals and a succession of time corresponding analog ramp signals, each analog input signal and time corresponding analog ramp signal being spaced apart temporally, each of the analog input signal and corresponding analog ramp signal being received at successive single slope ADCs, such that each single slope ADC provides a digital representation of the analog input signal input thereto using the time corresponding analog ramp signal.

## Patentansprüche

1. Analog-Digital Wandler, ADW, mit:
einer Vielzahl von Ein-Rampen-ADWs (32, 34, 36, 38), wobei jeder Ein-Rampen-ADW aufweist:
einen analogen Eingang, der dazu betreibbar ist, ein analoges Eingangssignal zu empfangen;
einen Rampeneingang, der dazu betreibbar ist, ein analoges Rampensignal zu empfangen;
einen Komparator (16), der dazu betreibbar ist, das analoge Eingangssignal mit dem analogen Rampensignal zu vergleichen; und
einen Ausgang, der dazu betreibbar ist, eine digitale Darstellung des analogen Eingangssignals basierend auf dem Vergleich zu erzeugen, wobei die Vielzahl von Ein-Rampen-ADWs (32, 34, 36, 38) dazu betreibbar sind, die analogen Rampensignale, die voneinander phasenverschoben sind, und die analogen Eingangssignale, die zeitlich voneinander beabstandet sind und an einen gemeinsamen analogen Eingang des Analog-Digital-Wandlers gekoppelt sind, zu empfangen; und
einen Rampengenerator (39), der dazu betreibbar ist, die analogen Rampensignale für jeden der Vielzahl von Ein-Rampen-ADWs (32, 34, 36, 38) zu erzeugen; und
digitale Ausgangsschaltung, die dazu betreibbar ist, die Ausgänge von jedem der Vielzahl von Ein-Rampen-ADWs (32, 34, 36, 38) zu empfangen und eine digitale Darstellung des analogen Eingangssignals basierend darauf zu erzeugen;
wobei die Vielzahl von Ein-Rampen-ADWs (32, 34, 36, 38) vier Ein-Rampen-ADWs aufweisen und
die vier Ein-Rampen-ADWs so betreibbar sind, dass zu jedem Betriebszeitpunkt:
ein erster Ein-Rampen-ADW in einem Rücksetzmodus ist;
ein zweiter Ein-Rampen-ADW das analoge Eingangssignal empfängt;
ein dritter Ein-Rampen-ADW das analoge Eingangssignal in eine korrespondierende digitale Darstellung umwandelt; und
ein vierter Ein-Rampen-ADW eine digitale Darstellung eines analogen Eingangssignals eines vorherigen Taktzyklus übermittelt;
wobei der Rampengenerator (39) Schaltung aufweist, um das analoge Rampensignal für jeden der Vielzahl von Ein-Rampen-ADWs (32, 34, 36, 38) gleichzeitig zu erzeugen;
wobei der Rampengenerator (39) dazu betreibbar ist, eine Vielzahl von Rampensignalen zu erzeugen, die alle voneinander phasenverschoben sind, und derart, dass aufeinander folgende Rampensignale um eine einzige Taktperiode phasenverschoben sind.

2. ADW nach Anspruch 1, wobei die Vielzahl von Ein-Rampen-ADWs (32, 34, 36, 38) dazu betreibbar sind, eine Abfolge zeitlich korrespondierender analoger Rampensignale zu empfangen, die zeitlich beabstandet sind, wobei die zeitlich korrespondierenden analogen Rampensignale an aufeinander folgenden Ein-Rampen-ADWs empfangen werden, so dass jeder Ein-Rampen-ADW eine digitale Darstellung des analogen Eingangssignals bereitstellt, das unter Verwendung seines zeitlich korrespondierenden analogen Rampensignals eingegeben worden ist.

3. ADW nach Anspruch 1, wobei der Rampengenerator (39) aufweist:
eine erste Schaltung zum Erzeugen einer Vielzahl erster analoger Rampensignale; und
eine Vielzahl zweiter Schaltungen, wobei jede zweite Schaltung einem Ein-Rampen-ADW entspricht und dazu betreibbar ist, eine Vielzahl zweiter Rampensignale basierend auf einem empfangenen ersten analogen Rampensignal zu erzeugen.

4. ADW nach Anspruch 3, wobei die erste Schaltung des Rampengenerators (39) dazu betreibbar ist, eine Vielzahl erster analoger Rampensignale zu erzeugen, die alle voneinander phasenverschoben sind, und derart, dass aufeinander folgende erste analoge Rampensignale um eine einzige Taktperiode phasenverschoben sind.

5. ADW nach Anspruch 3, wobei:
die ersten analogen Rampensignale grobe Rampensignale aufweisen; und
die zweiten analogen Rampensignale feine Rampensignale aufweisen.

6. ADW nach Anspruch 1, wobei der Rampengenerator (39) aufweist:
eine Vielzahl resistiver Elemente, die in Reihe angeordnet sind, um einen Ring zu bilden;
ein Switch-Netzwerk;
erste und zweite Stromversorgungen, jede auf einem anderen Pegel; und
einen Controller, der dazu ausgelegt ist, das Switch-Netzwerk zu steuern, um eine erste Stromversorgung der Reihe nach mit jedem Knoten des Widerstandsrings zu verbinden, während eine zweite Stromversorgung ebenfalls mit einem Knoten diametral entgegengesetzt zu dem Knoten, mit dem die erste Stromversorgung verbunden wird, verbunden wird, so dass die ersten und zweiten Versorgungen stets mit diametral entgegengesetzten Knoten verbunden sind, und so dass erste und zweite Stromversorgungsverbindungen während der Rampenerzeugung effektiv um den Ring rotieren, wodurch eine Vielzahl von Rampenausgängen bereitgestellt werden, jede von einem anderen Knoten des Widerstandsrings.

7. ADW nach Anspruch 6, wobei der Widerstandsring aus viermal so vielen Widerständen wie Rampenausgängen besteht, wobei jeder Rampenausgang von zwei diametral entgegengesetzten Knoten, die zusammen gemultiplext sind, genommen wird.

8. ADW nach Anspruch 6, wobei der Rampengenerator (39) zwei Switches für jeden der Knoten aufweist, um die selektive Verbindung jedes Knotens mit jeder Stromversorgung zu ermöglichen.

9. ADW nach Anspruch 1, wobei jeder Ein-Rampen-ADW eine Abtast-Halte-Schaltung aufweist, die dazu betreibbar ist, das analoge Eingangssignal abzutasten und eine Spannung des abgetasteten analogen Eingangssignals während der Umwandlung in eine korrespondierende digitale Darstellung zu halten.

10. Verfahren für Analog-Digital-Umwandlung, das umfasst:
Empfangen eines analogen Eingangssignals und eines analogen Rampensignals an jedem einer Vielzahl von Ein-Rampen-Analog-Digital-Wandlern, ADWs (32, 34, 36, 38), wobei jedes analoge Eingangssignal an ein umzuwandelndes gemeinsames analoges Eingangssignal gekoppelt ist;
wobei die Vielzahl von Ein-Rampen-ADWs vier Ein-Rampen-ADWs aufweisen; und
Vergleichen des analogen Eingangssignals und des analogen Rampensignals; und
Betreiben jedes der Ein-Rampen-ADWs, eine digitale Darstellung des analogen Eingangssignals in Abhängigkeit von dem analogen Eingangssignal und dem analogen Rampensignal bereitzustellen,
wobei ein analoges Eingangssignal, das von einem der Ein-Rampen-ADWs (32, 34, 36, 38) empfangen wird, zeitlich von einem analogen Eingangssignal beabstandet ist, das von einem anderen Ein-Rampen-ADW empfangen wird, und die analogen Rampensignale, die von den Ein-Rampen-ADWs (32, 34, 36, 38) empfangen werden, voneinander phasenverschoben sind, wobei aufeinander folgende Rampensignale um eine einzige Taktperiode phasenverschoben sind;
wobei zu jedem Zeitpunkt ein erster Ein-Rampen-ADW im Rücksetzmodus ist, ein zweiter Ein-Rampen-ADW das analoge Eingangssignal empfängt, ein dritter Ein-Rampen-ADW das analoge Eingangssignal in eine korrespondierende digitale Darstellung umwandelt, und ein vierter Ein-Rampen-ADW eine digitale Darstellung eines analogen Eingangssignals eines vorhergehenden Taktzyklus übermittelt;
Betreiben eines Rampengenerators, um die analogen Rampensignale für jeden der Vielzahl von Ein-Rampen-Analog-Digital-Wandlern gleichzeitig zu erzeugen, wobei die analogen Rampensignale alle voneinander phasenverschoben sind und aufeinander folgende Rampensignale um eine einzige Taktperiode phasenverschoben sind.

11. Verfahren nach Anspruch 10, das des Weiteren das Empfangen einer Abfolge analoger Eingangssignale und eine Abfolge zeitlich korrespondierender analoger Rampensignale umfasst, wobei jedes analoge Eingangssignal und zeitlich korrespondierende analoge Rampensignal zeitlich beabstandet sind und jedes des analogen Eingangssignals und des korrespondierenden analogen Rampensignals an aufeinander folgenden Ein-Rampen-ADWs empfangen wird, so dass jeder Ein-Rampen-ADW eine digitale Darstellung des analogen Eingangssignals bereitstellt, das unter Verwendung des zeitlich korrespondierenden analogen Rampensignals dort eingegeben worden ist.

## Revendications

1. Convertisseur analogique à numérique, CAN, comprenant :
une pluralité de CAN à pente unique (32, 34, 36, 38), chaque CAN à pente unique comprenant :
une entrée analogique utilisable pour recevoir un signal d'entrée analogique ;
une entrée de rampe utilisable pour recevoir un signal de rampe analogique ;
un comparateur (16) utilisable pour comparer le signal d'entrée analogique au signal de rampe analogique ; et
une sortie utilisable pour produire une représentation numérique du signal d'entrée analogique sur la base de la comparaison, dans lequel la pluralité de CAN à pente unique (32, 34, 36, 38) sont utilisables pour recevoir les signaux de rampe analogiques qui sont déphasés les uns par rapport aux autres et les signaux d'entrée analogiques qui sont espacés dans le temps les uns des autres et sont couplés à une entrée analogique commune du convertisseur analogique à numérique ; et
un générateur (39) de rampe qui est utilisable pour générer les signaux de rampe analogiques pour chacun de la pluralité de CAN à pente unique (32, 34, 36, 38) ; et
un ensemble de circuits numériques de sortie utilisables pour recevoir les sorties de chacun de la pluralité de CAN à pente unique (32, 34, 36, 38) et pour produire représentation numérique du signal d'entrée analogique sur la base de celles-ci ;
dans lequel la pluralité de CAN à pente unique (32, 34, 36, 38) comprend quatre CAN à pente unique et
les quatre CAN à pente unique sont utilisables de telle manière que, à un moment quelconque de fonctionnement :
un premier CAN à pente unique est dans un mode de réinitialisation ;
un deuxième CAN à pente unique reçoit le signal d'entrée analogique ;
un troisième CAN à pente unique convertit le signal d'entrée analogique en une représentation numérique correspondante ; et
un quatrième CAN à pente unique transporte une représentation numérique d'un signal d'entrée analogique d'un cycle d'horloge précédent;
dans lequel le générateur (39) de rampe comprend un ensemble de circuits pour générer simultanément le signal de rampe analogique pour chacun de la pluralité de CAN à pente unique (32, 34, 36, 38) ;
dans lequel le générateur (39) de rampe est utilisable pour produire une pluralité de signaux de rampe qui sont tous déphasés les uns par rapport aux autres, et tels que des signaux de rampe successifs sont déphasés d'une seule période d'horloge.

2. CAN selon la revendication 1, dans lequel la pluralité de CAN à pente unique (32, 34, 36, 38) sont utilisables pour recevoir une succession de signaux de rampe analogiques correspondants dans le temps qui sont espacés temporellement, les signaux de rampe analogiques correspondants dans le temps sont reçus au niveau de CAN à pente unique successifs, de telle sorte que chaque CAN à pente unique délivre une représentation numérique du signal d'entrée analogique entré en utilisant son signal de rampe analogique correspondant dans le temps.

3. CAN selon la revendication 1, dans lequel le générateur (39) de rampe comprend :
un premier circuit pour générer une pluralité de premiers signaux de rampe analogiques ; et
une pluralité de deuxièmes circuits, chaque deuxième circuit respectif pour un CAN à pente unique et utilisable pour produire une pluralité de deuxièmes signaux de rampe sur la base d'un premier signal de rampe analogique reçu.

4. CAN selon la revendication 3, dans lequel le premier circuit du générateur (39) de rampe est utilisable pour produire une pluralité de premiers signaux de rampe analogiques qui sont tous déphasés les uns par rapport aux autres, et tels que des premiers signaux de rampe analogiques successifs sont déphasés d'une seule période d'horloge.

5. CAN selon la revendication 3, dans lequel :
les premiers signaux de rampe analogiques comprennent des signaux de rampe grossiers ; et
les deuxièmes signaux de rampe analogiques comprennent des signaux de rampe fins.

6. CAN selon la revendication 1, dans lequel le générateur (39) de rampe comprend :
une pluralité d'éléments résistifs agencés en série de façon à former un anneau ;
un réseau de commutation ;
des première et deuxième alimentations électriques, chacune à un niveau différent ; et
un contrôleur agencé pour commander le réseau de commutation de façon à connecter une première alimentation électrique successivement à chaque noeud de l'anneau de résistances tout en connectant également une deuxième alimentation électrique à un noeud diamétralement opposé au noeud auquel la première alimentation électrique est connectée, de telle sorte que les première et deuxième alimentations sont toujours connectées à des noeuds diamétralement opposés et de telle sorte que des première et deuxième connexions d'alimentation électrique tournent effectivement autour de l'anneau lors d'une génération de rampe, délivrant ainsi une pluralité de sorties de rampe, chacune depuis un noeud différent de l'anneau de résistances.

7. CAN selon la revendication 6, dans lequel l'anneau de résistances est composé de quatre fois plus de résistances que de sorties de rampe, chaque sortie de rampe étant prise de deux noeuds diamétralement opposés multiplexés ensemble.

8. CAN selon la revendication 6, dans lequel le générateur (39) de rampe comprend deux commutateurs pour chacun des noeuds, de façon à permettre une connexion sélective de chaque noeud à chaque alimentation électrique.

9. CAN selon la revendication 1, dans lequel chaque CAN à pente unique comprend un circuit d'échantillonnage et de maintien qui est utilisable pour échantillonner le signal d'entrée analogique et pour maintenir une tension du signal d'entrée analogique échantillonné lors d'une conversion en une représentation numérique correspondante.

10. Procédé de conversion analogique à numérique comprenant :
la réception d'un signal d'entrée analogique et d'un signal de rampe analogique au niveau de chacun d'une pluralité de convertisseurs analogique à numérique, CAN, à pente unique (32, 34, 36, 38), chaque signal d'entrée analogique étant couplé à un signal d'entrée analogique commun à convertir ;
dans lequel la pluralité de CAN à pente unique comprend quatre CAN à pente unique ; et
la comparaison du signal d'entrée analogique et du signal de rampe analogique ; et
l'utilisation de chacun des CAN à pente unique pour délivrer une représentation numérique du signal d'entrée analogique en fonction du signal d'entrée analogique et du signal de rampe analogique,
un signal d'entrée analogique reçu par un des CAN à pente unique (32, 34, 36, 38) étant espacé dans le temps d'un signal d'entrée analogique reçu par un autre CAN à pente unique et les signaux de rampe analogiques reçus par les CAN à pente unique (32, 34, 36, 38) étant déphasés les uns par rapport aux autres, dans lequel des signaux de rampe successifs sont déphasés d'une seule période d'horloge ;
dans lequel, à un quelconque moment, un premier CAN à pente unique est dans un mode de réinitialisation, un deuxième CAN à pente unique reçoit le signal d'entrée analogique, un troisième CAN à pente unique convertit le signal d'entrée analogique en une représentation numérique correspondante et un quatrième CAN à pente unique transporte une représentation numérique d'un signal d'entrée analogique d'un cycle d'horloge précédent;
l'utilisation d'un générateur de rampe pour générer simultanément les signaux de rampe analogiques pour chacun de la pluralité de convertisseurs analogique à numérique à pente unique, les signaux de rampe analogiques étant tous déphasés les uns par rapport aux autres, et des signaux de rampe successifs étant déphasés d'une seule période d'horloge.

11. Procédé selon la revendication 10 comprenant en outre la réception d'une succession de signaux d'entrée analogiques et d'une succession de signaux de rampe analogiques correspondants dans le temps, chaque signal d'entrée analogique et signal de rampe analogique correspondant dans le temps étant espacés temporellement, chacun du signal d'entrée analogique et du signal de rampe analogique correspondant étant reçus au niveau de CAN à pente unique successifs, de telle sorte que chaque CAN à pente unique délivre une représentation numérique du signal d'entrée analogique entré dans celui-ci en utilisant le signal de rampe analogique correspondant dans le temps.
